# EUROPEAN PATENT SPECIFICATION

(11) **EP 2 702 900 B1**
(45) Date of publication and mention of the grant of the patent: **30.09.2015**
(21) Application number: 12182545.9
(22) Date of filing: 31.08.2012
(51) Int. Cl.: A47B 88/04, H05K 7/14

(54) **Mount bracket for slide assembly**
Beschlag für eine Schubladenschiene
Raccord pour une glissière

(43) Date of publication of application: 05.03.2014
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Huang, Chien-Li, Kaohsiung City (TW); Chen, Yao-Tsung, Kaohsiung City (TW); Wang, Chun-Chiang, Kaohsiung City (TW)
(74) Representative: Viering, Jentschura & Partner Patent- und Rechtsanwälte

(56) References cited:
- GB-A- 2 456 016

## Description

### FIELD OF THE INVENTION

The present invention relates to a mount bracket, and more particularly, to a toolless mount bracket for a slide assembly by one assembler.

### BACKGROUND OF THE INVENTION

Conventional mount brackets for a slide assembly are disclosed in U.S. Patent No. 7,857,145 to Mushan, U.S. Patent No. 8,104,626 to Huang, and U.S. Patent No. 8, 146,756 to Brock as well as in GB2456016.

The conventional mount brackets are complicated in shape and structure, and require two assemblers to install the mount brackets at the front and rear sides of the rack. If only one assembler is available, the assembler has to install the locking mechanism respectively at the front and rear side of the rack. It requires too much time and labor to install the mount bracket.

The present invention intends to provide a toolless mount bracket for a slide assembly, and requires only one assembler at one position to complete the installation.

### SUMMARY OF THE INVENTION

According to one aspect of the present invention, the mount bracket is connected to a slide assembly and installed to a post of a rack. The post has a plurality of holes. The mount bracket comprises a fixing frame having a side wall, an end wall, and two protrusions respectively extending from a top side and a bottom side of the sidewall. The two protrusions and the side wall define a first path. The side wall has a recess and defines a second path. An installation unit is fixed to the end wall of the fixing frame. A movable member has a first board and a second board, wherein the first board is inserted into the first path of the fixing frame. The first board has a contact portion and a support frame. The support frame is inserted into the second path of the fixing frame and the contact portion is located adjacent to the second board. The support frame has an engaging hole. The second board has a plurality of holes which are located corresponding to the installation unit. A positioning member has a fixing portion, a resilient arm, an activation portion and an engaging portion. The fixing portion is fixed to the side wall of the fixing frame. The resilient arm is connected between the fixing portion and the activation portion. The activation portion extends an angle from one end of the resilient arm. The engaging portion is located on the resilient arm and located corresponding to the engaging hole of the movable member. A release member is movably connected to the first board of the movable member and has a push block which is located corresponding to the activation portion of the positioning member. When in assembling, the contact portion of the movable member and the second board contact the inside and outside of the post of the rack. The installation unit is located corresponding to the holes of the post. The fixing frame is pushed toward the post to insert the installation unit into the holes of the post. Only the engaging portion of the positioning member is engaged with the engaging hole of the movable member to connect the movable member to the fixing frame. When pushing the release member, the push block of the release member contacts the activation portion of the positioning member. The resilient arm of the positioning member is lifted relative to the movable member. The engaging portion of the positioning member is disengaged from the engaging hole of the movable member. The movable member is movable relative to the fixing frame. The installation unit of the mount bracket is removed from the post.

Preferably, the side wall of the fixing frame has two connection holes. The first board of the movable member has two through holes located corresponding to the connection holes of the side wall. The through holes are respectively cooperated with the connection holes. The through holes or the connection holes are in the form of elongated hole. Two connection members extend through the through holes and the connection holes to movably connect the movable member to the fixing frame.

Preferably, the side wall of the fixing frame has a stop which extends to a window of the side wall. The stop is located corresponding to the release member.

Preferably, the installation unit has two installation members and a positioning block is located between the two installation members. The positioning block has a threaded hole defined therethrough and the threaded hole is located corresponding to the end wall of the fixing frame.

Preferably, the release member has an operation portion and a connection portion extending between the push block and the operation portion. The push block has an inclined face located corresponding to the activation portion of the positioning member.

Preferably, the push block of the release member has a neck connected to the connection portion and the first board has a slot through which the neck extends so that the release member is movably connected to the support frame of the movable member.

Preferably, the side wall of the fixing frame has a stop which is located corresponding to the push block or the neck such that the release member does not be separated from the movable member.

According to another aspect of the present invention, the mount bracket comprises a fixing frame having a side wall, an end wall extending perpendicularly from an end of the side wall, and two protrusions respectively extending from a top side and a bottom side of the side wall. The two protrusions and the side wall define a first path. The side wall has two connection holes, a recess located between the connection holes, and a stop. The recess extends to the end wall and defines a second path. A window is defined through the side wall and communicates with the recess. An installation unit is fixed to the end wall of the fixing frame and comprises two installation members. A movable member has a first board and a second board which extends an angle from the first board. The first board is inserted into the first path of the fixing frame. The first board has a through hole, a contact portion and a slot. The through hole is located corresponding to the connection hole. A connection member extends through the through hole and the connection hole to movably connect the movable member to the fixing frame. The contact portion is located adjacent to the second board. The support frame is inserted into the second path of the fixing frame and the support frame has an engaging hole. The second board has a plurality of holes which are located corresponding to the installation members of the installation unit. A positioning member has a fixing portion, a resilient arm, an activation portion and an engaging portion. The fixing portion is fixed to the side wall of the fixing frame. The resilient arm is connected between the fixing portion and the activation portion. The activation portion extends an angle from one end of the resilient arm. The activation portion is located on the resilient arm and located corresponding to the engaging hole of the movable member. The activation portion and the engaging portion extend through the window of the fixing frame. A release member has a push block, an operation portion and a connection portion which is connected between the push block and the operation portion. The push block has an inclined face which is located corresponding to the activation portion of the positioning member. The release member is movably connected to the support frame of the movable member.

The primary object of the present invention is to provide a mount bracket for a slide assembly and the installation requires only one assembler who does not need to move to complete the assembling process.

When assembling the mount bracket to the post of the rack, no tool needed, the assembler simply connects the mount bracket to the post of the rack and pushes the mount bracket. The mount bracket is connected to the post of the rack.

The present invention will become more obvious from the following description when taken in connection with the accompanying drawings which show, for purposes of illustration only, a preferred embodiment in accordance with the present invention.

### BRIEF DESCRIPTION OF THE DRAWINGS

Fig. 1 is an exploded view to show the mount bracket of the present invention;

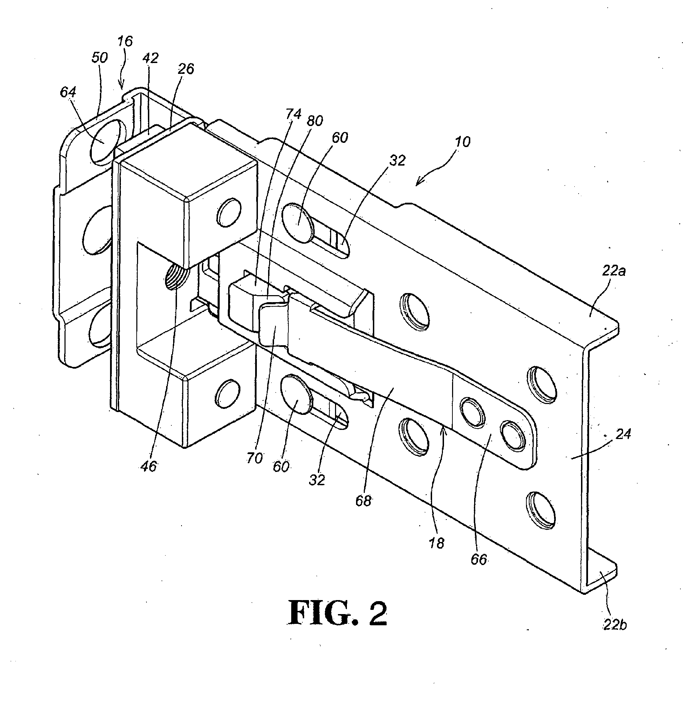

Fig. 2 is a perspective view to show the mount bracket of the present invention;
Fig. 3 is another perspective view viewed from rear side of the mount bracket in Fig. 1;
Fig. 4 shows the installation direction of the mount bracket of the present invention;
Fig. 5 is an end cross sectional view to show the installation of the mount bracket of the present invention;

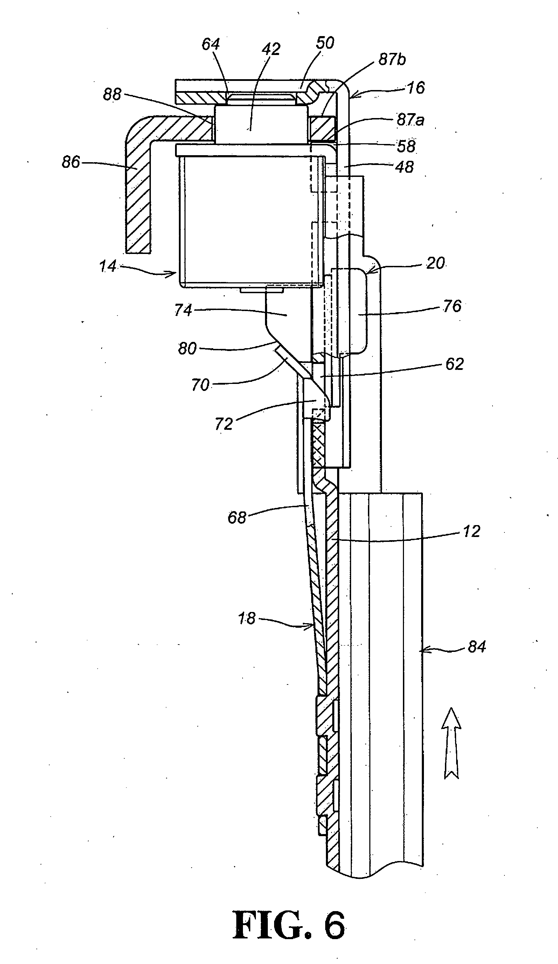

Fig. 6 is an end cross sectional view to show that the mount bracket of the present invention is installed, and
Fig. 7 shows that the mount bracket of the present invention is released.

### DETAILED DESCRIPTION OF THE PREFERRED EMBODIMENT

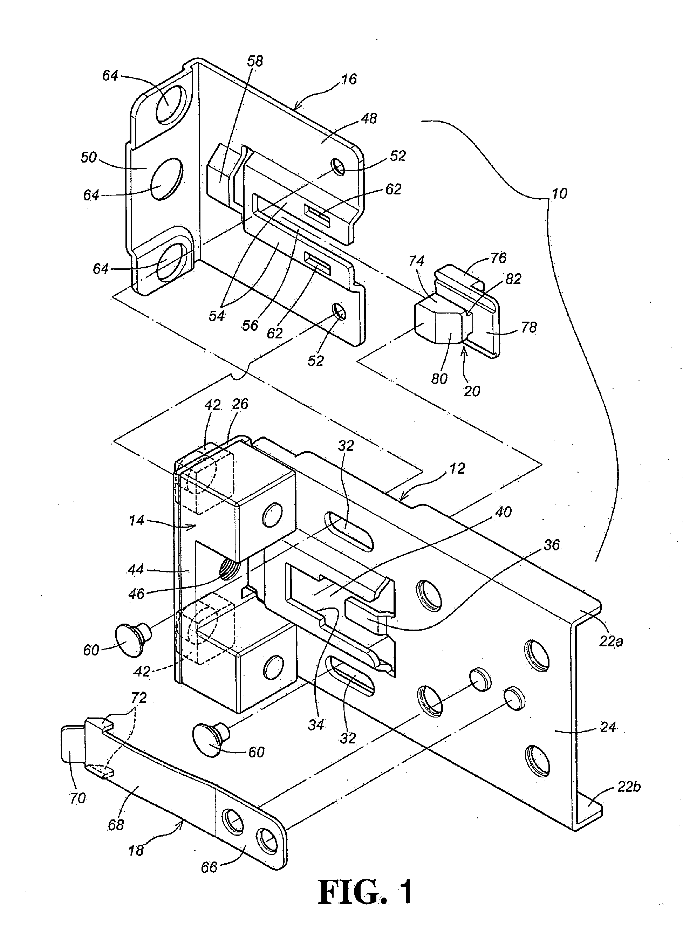

Referring to Fig. 1, the mount bracket 10 of the present invention comprises a fixing frame 12, an installation unit 14, a movable member 16, a positioning member 18 and a release member 20.

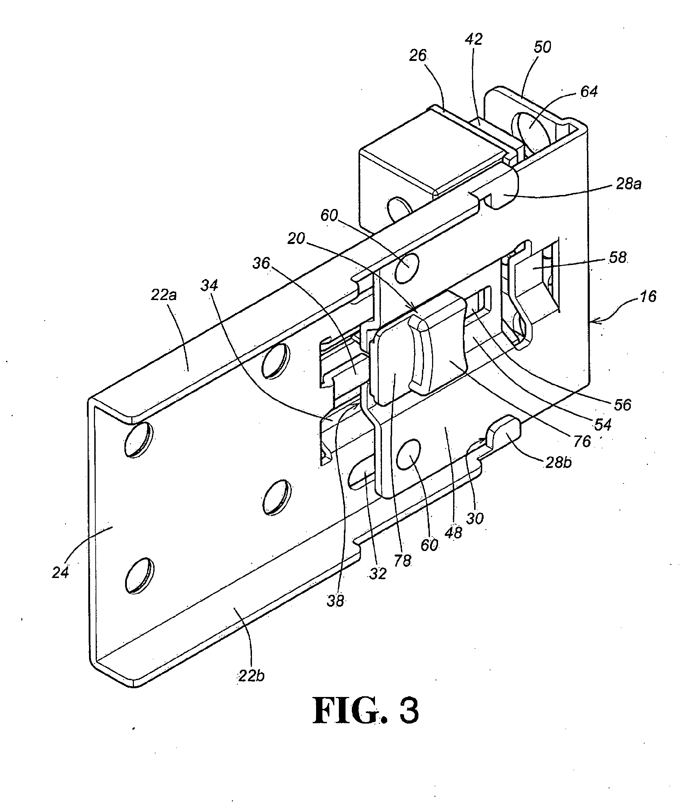

The fixing frame 12 has a top flange 22a, a bottom flange 22b, a side wall 24 connected between the top and bottom flanges 22a, 22b, and an end wall 26 substantially and perpendicularly extending from one end of the side wall 24. The top flange 22a has a downward protrusion 28a and the bottom flange 22b has an upward protrusion 28b which is located corresponding to the protrusion 28a. The two protrusions 28a, 28b and the side wall 24 define a first path 30 as shown in Fig. 3. The side wall 24 has two connection holes 32, a recess 34 located between the connection holes 32, and a stop 36. The recess 34 extends to the adjacent end wall 26 and defines a second path 38 as shown in Fig. 3. A window 40 is defined through the side wall 24 and communicating with the recess 34. The stop 36 extends to the window 40.

The installation unit 14 is fixed to the end wall 26 of the fixing frame 12 and comprises two installation members 42 and a positioning block 44 connected between the two installation members 42. The positioning block 44 has a threaded hole 46 defined therethrough and located corresponding to the end wall 26 so that a bolt (not shown) is threadedly connected to the threaded hole 46.

The movable member 16 has a first board 48 and a second board 50 extending an angle from the first board 48. The first board 48 is inserted into the first path 30 of the fixing frame 12 and comprises two through holes 52, two support frames 54, a slot 56 located between the support frames 54, and a contact portion 58 located adjacent to the second board 50. The through holes 52 are located corresponding to the connection holes 32. The through holes 52 or the connection holes (32) are in the form of elongated slots. Two connection members 60 extend through the through holes 52 and the connection holes 32 to movably connect the movable member 16 to the fixing frame 12. Each of the support frames 54 has an engaging hole 62. The second board 50 has a plurality of holes 64 which are located corresponding to the installation members 42 and the threaded hole 46.

The positioning member 18 has a fixing portion 66, a resilient arm 68, an activation portion 70 and an engaging portion 72, wherein the fixing portion 66 is fixed to the side wall 24 of the fixing frame 12, and the resilient arm 68 is connected between the fixing portion 66 and the activation portion 70. The activation portion 70 extends an angle from one end of the resilient arm 68. The engaging portions 72 extend from two sides of the resilient arm 68. The activation portion 70 and the engaging portions 72 extend through the window 40 of the fixing frame 12.

The release member 20 has a push block 74, an operation portion 76 and a connection portion 78 connected between the push block 74 and the operation portion 76. The push block 74 has an inclined face 80 which is located corresponding to the activation portion 70 of the positioning member 18. The push block 74 is connected to the connection portion 78 by a neck 82.

The movable member 16 is inserted into the first path 30 of the fixing frame 12 by inserting the first board 48 inserted into the first path 30 of the fixing frame 12. The support frames 54 are inserted into the second path 38 of the side wall 24. The neck 82 of the release member 20 is inserted into the slot 56 of the movable member 16 so that the release member 20 is movably connected to the support frames 54. The neck 82 or the push block 74 is located corresponding to the stop 36 of the fixing frame 12 to restrict the release member 20 and avoid the release member 20 from being separated from the movable member 16. The inclined face 80 of the push block 74 is located corresponding to the activation portion 70 of the positioning member 18.

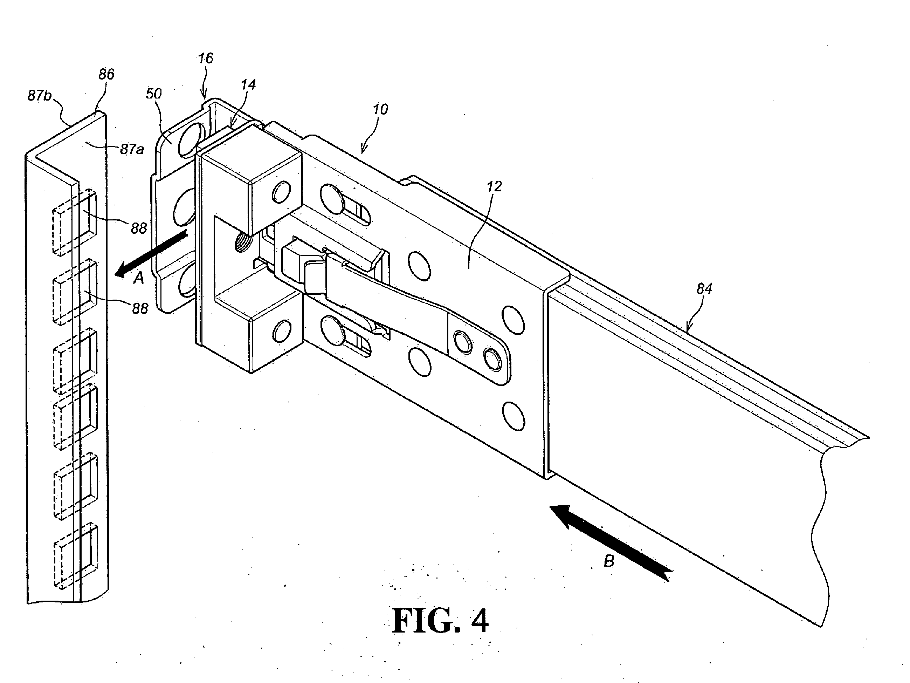

As shown in Fig. 4, when in use, the fixing frame 12 is connected to the slide assembly 84 whose two ends each have one mount bracket 10 connected thereto, while only one is disclosed in the drawings. The four posts 86 of the rack form an upright support structure and each post 86 has a plurality of holes 88 (only one post is disclosed). When the mount bracket 10 is installed to the post 86, the user holds the slide assembly 84 and the mount bracket 10 faces the post 86 at the remote end. The mount bracket 10 is installed along the direction "A" shown in Fig. 4 to contact the post 86 and then moves the slide assembly 84 in the direction "B" to move the fixing frame 12 toward the post 86. The fixing frame 12 is then locked to the movable member 16 to install the mount bracket 10 to the post 86.

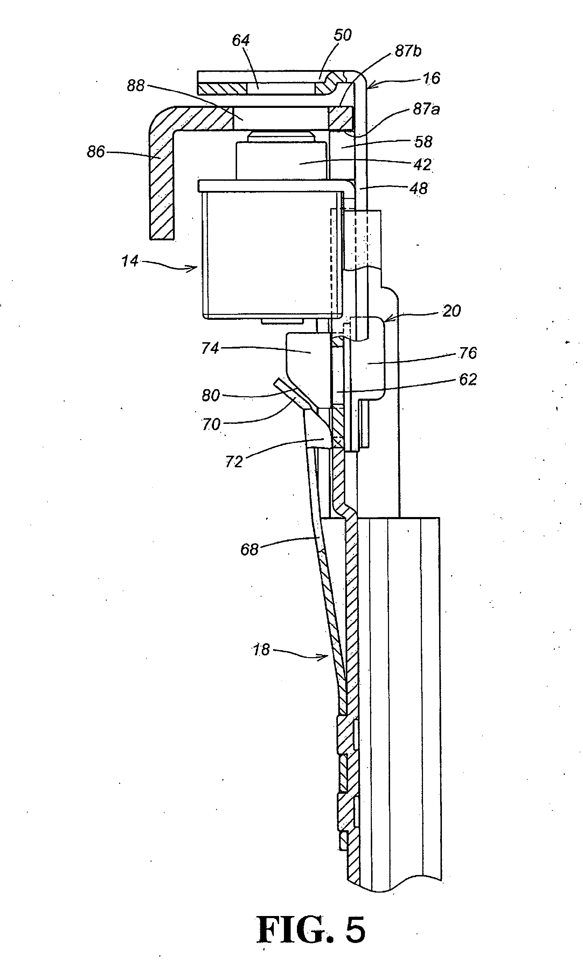

During the installation action, when the mount bracket 10 is in contact with the post 86 in the direction "A", as shown in Fig. 5, the contact portion 58 of the movable member 16 and the second board 50 are in contact with the inside 87a and outside 87b of the post 86 of the rack, so that the movable member 16 temporarily contacts the post 86. The installation member 42 of the installation unit 14 is located corresponding to the holes 88 of the post 86. When the slide assembly 84 is moved toward the direction "B", the fixing frame 12 is pushed toward the post 86 to insert the installation member 42 of the installation unit 14 into the holes 88 of the of the post 86. The fixing frame 12 is movable relative to the movable member 16 so that the engaging portion 72 of the positioning member 18 is engaged with the engaging hole 62 of the movable member 16 to connect the movable member 16 to the fixing frame 12. The mount bracket 10 is conveniently installed at the remote end by the extension of the slide assembly 84. Only one assembler is required to quickly install the slide assembly 84 and the mount bracket 10 to the post 86.

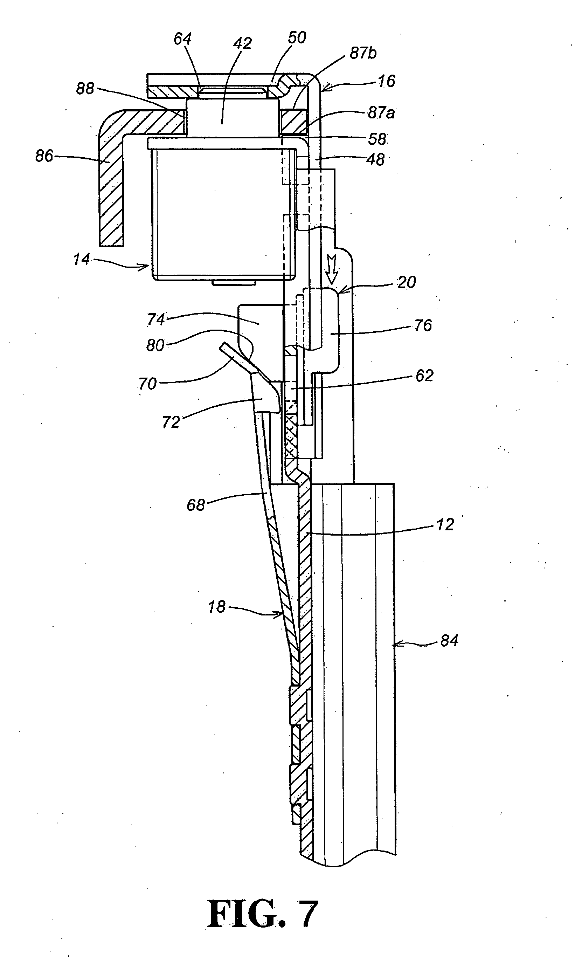

When releasing the connection between the fixing frame 12 and the movable member 16 so as to remove the mount bracket 10 from the post 86 as shown in Fig. 7, the operation portion 76 of the release member 20 is pushed, the inclined face 80 of the push block 74 of the release member 20 contacts the activation portion 70 of the positioning member 18 so that the resilient arm 68 of the positioning member 18 is lifted relative to the movable member 16. The engaging portion 72 of the positioning member 18 is disengaged from the engaging hole 62 of the movable member 16. The movable member 16 is movable relative to the fixing frame 12. By pulling the fixing frame 12, the installation member 42 of the mount bracket 10 is removed from the post 86.

While we have shown and described the embodiment in accordance with the present invention, it should be clear to those skilled in the art that further embodiments may be made without departing from the scope of the present invention.

## Claims

1. A mount bracket (10) connected to a slide assembly (84) and installed to a post (86) of a rack, the post (86) having a plurality of holes (88), the mount bracket (10) comprising:
a fixing frame (12) having a side wall (24), an end wall (26), and two protrusions (28a, 28b) respectively extending from a top side and a bottom side of the sidewall (24), the two protrusions (28a, 28b) and the side wall (24) defining a first path (30), the side wall (24) having a recess (34) and defining a second path (38);
an installation unit (14) fixed to the end wall (26) of the fixing frame (12);
a movable member (16) having a first board (48) and a second board (50), the first board (48) inserted into the first path (30) of the fixing frame (12), the first board (48) having a contact portion (58) and a support frame (54), the support frame (54) inserted into the second path (38) of the fixing frame (12) and the contact portion (58) located adjacent to the second board (50), the support frame (54) having an engaging hole (62), the second board (50) having a plurality of holes (64) which are located corresponding to the installation unit (14);
a positioning member (18) having a fixing portion (66), a resilient arm (68), an activation portion (70) and an engaging portion (72), the fixing portion (66) fixed to the side wall (24) of the fixing frame (12), the resilient arm (68) connected between the fixing portion (66) and the activation portion (70), the activation portion (70) extending an angle from an end of the resilient arm (68), the engaging portion (72) located on the resilient arm (68) and located corresponding to the engaging hole (62) of the movable member (16);
a release member (20) movably connected to the first board (48) of the movable member (16) and having a push block (74) which is located corresponding to the activation portion (70) of the positioning member (18);
and when assembled, the contact portion (58) of the movable member (16) and the second board (50) are adapted to contact the inside (87a) and outside (87b) of the post (86) of the rack, the installation unit (14) is located corresponding to the holes (88) of the post (86), the fixing frame (12) is pushed toward the post (86) to insert the installation unit (14) into the holes (88) of the post (86), only the engaging portion (72) of the positioning member (18) is engaged with the engaging hole (62) of the movable member (16) to connect the movable member (16) to the fixing frame (12), and
when pushing the release member (20), the push block (74) of the release member (20) contacts the activation portion (70) of the positioning member (18), the resilient arm (68) of the positioning member (18) is lifted relative to the movable member (16), the engaging portion (72) of the positioning member (18) is disengaged from the engaging hole (62) of the movable member (16), the movable member (16) is movable relative to the fixing frame (12), the installation unit (14) of the mount bracket (10) is adapted to be removed from the post (86).

2. The mount bracket as claimed in claim 1, wherein the side wall (24) of the fixing frame (12) has two connection holes (32), the first board (48) of the movable member (16) has two through holes (52) located corresponding to the connection holes (32) of the side wall (24), the through holes (52) are respectively cooperated with the connection holes (32), the through holes (52) or the connection holes (32) are in the form of elongated slots, two connection members (60) extend through the through holes (52) and the connection holes (32) to movably connect the movable member (16) to the fixing frame (12).

3. The mount bracket as claimed in claim 1, wherein the side wall (24) of the fixing frame (12) has a stop (36) which extends to a window (40) of the side wall (24), the stop (36) is located corresponding to the release member (20).

4. The mount bracket as claimed in claim 1, wherein the installation unit (14) has two installation members (42) and a positioning block (44) located between the two installation members (42), the positioning block (44) has a threaded hole (46) defined therethrough and the threaded hole (46) is located corresponding to the end wall (26) of the fixing frame (12).

5. The mount bracket as claimed in claim 1, wherein the release member (20) has an operation portion (76) and a connection portion (78) extending between the push block (74) and the operation portion (76), the push block (74) has an inclined face (80) located corresponding to the activation portion (70) of the positioning member (18).

6. The mount bracket as claimed in claim 1, wherein the push block (74) of the release member (20) has a neck (82) connected to the connection portion (78) and the first board (48) has a slot (56) through which the neck (82) extends so that the release member (20) is movably connected to the support frame (54) of the movable member (16).

7. The mount bracket as claimed in claim 6, wherein the side wall (24) of the fixing frame (12) has a stop (36) which is located corresponding to the push block (74) or the neck (82) such that the release member (20) does not be separated from the movable member (16).

## Patentansprüche

1. Ein Befestigungsbügel (10), der an einer gleitbaren Montage (84) befestigt und an einem Stab (86) eines Gestells montiert ist, wobei dieser Stab (86) mehrere Löcher (88) aufweist und der Befestigungsbügel (10) aus den folgenden Elementen umfassend:
einem Befestigungsrahmen (12) mit einer Seitenwand (24), einer Endwand (26) und mit zwei Vorsprüngen (28a, 28b), wovon sich einer von einer oberen Seite bzw. einer von einer unteren Seite der Seitenwand (24) erstreckt; mit den beiden Vorsprüngen (28a, 28b) und der Seitenwand (24) ein erster Durchlass (30) gebildet wird; die Seitenwand (24) eine Aussparung (34) aufweist und einen zweiten Durchlass (38) bildet;
einer Montageeinheit (14), die an der Endwand (26) des Befestigungsrahmens (12) befestigt ist;
einer beweglichen Komponente (16) mit einem ersten Plättchen (48) und einem zweiten Plättchen (50); das erste Plättchen (48) in den ersten Durchlass (30) des Befestigungsrahmens (12) eingesetzt ist; das erste Plättchen (48) mit einem Kontaktelement (58) und einem Trägerrahmen (54) gebildet ist; der Trägerrahmen (54) in den zweiten Durchlass (38) des Befestigungsrahmens (12) eingesetzt und das Kontaktelement (58) angrenzend zum zweiten Plättchen (50) angeordnet ist; der Trägerrahmen (54) ein Einrastloch (62) aufweist, das zweite Plättchen (50) mit mehreren Löchern (64) gebildet ist, die in Übereinstimmung mit der Montageeinheit (14) geformt sind;
einem Positionierglied (18) mit einem Befestigungselement (66), einem federnden Arm (68), einer Betätigungslasche (70) und mit einer Einrastlasche (72), wobei das Befestigungselement (66) an der Seitenwand (24) des Befestigungsrahmens (12) befestigt ist, der federnde Arm (68) zwischen dem Befestigungselement (66) und der Betätigungslasche (70) montiert ist; sich die Betätigungslasche (70) in einem Winkel von einem Ende des federnden Arms (68) erstreckt und die Einrastlasche (72) am federnden Arm (68) und entsprechend dem Einrastloch (62) der beweglichen Komponente (16) angeordnet ist;
einem Ausrückglied (20), das beweglich am ersten Plättchen (48) der beweglichen Komponente (16) befestigt und mit einem Schiebeblock (74) gebildet ist, der an einer mit der Betätigungslasche (70) des Positioniergliedes (18) übereinstimmenden Stelle angeordnet ist;
nach dem Zusammensetzen das Kontaktelement (58) der beweglichen Komponente (16) und das zweite Plättchen (50) so ausgerichtet sind, damit sie mit der Innenseite (87a) und der Außenseite (87b) des Stabes (86) in Berührung kommen; die Montageeinheit (14) in Übereinstimmung mit den Löchern (88) des Stabes (86) angeordnet ist; der Befestigungsrahmen (12) auf den Stab (86) zu geschoben wird, um die Montageeinheit (14) in die Löcher (88) des Stabes (86) einzuführen, wobei nur die Einrastlasche (72) des Positioniergliedes (18) in das Einrastloch (62) der beweglichen Komponente (16) eingerastet wird, um diese bewegliche Komponente (16) am Befestigungsrahmen (12) zu befestigen, und
beim Anschieben des Ausrückgliedes (20) der Schiebeblock (74) dieses Ausrückgliedes (20) mit der Betätigungslasche (70) des Positioniergliedes (18) in Berührung kommt; der federnde Arm (68) des Positioniergliedes (18) relativ zur beweglichen Komponente (16) angehoben wird; die Einrastlasche (72) des Positioniergliedes (18) aus dem Einrastloch (62) der beweglichen Komponente (16) ausgerückt wird; die bewegliche Komponente (16) relativ zum Befestigungsrahmen (12) beweglich ist; die Montageeinheit (14) des Befestigungsbügels (10) aus dem Stab (86) entfernt wird.

2. Der Befestigungsbügel nach Anspruch 1, wobei die Seitenwand (24) des Befestigungsrahmens (12) zwei Montagelöcher (32) aufweist; das erste Plättchen (48) der beweglichen Komponente (16) mit zwei durchgehenden Löchern (52) gebildet ist, die entsprechend den Montagelöchem (32) der Seitenwand (24) gebildet sind; diese durchgehenden Löcher (52) je mit den Montagelöchern (32) zusammenwirken; die durchgehenden Löcher (52) oder Montagelöcher (32) in Form von Längslöchem gebildet sind; sich zwei Montageglieder (60) durch die durchgehenden Löcher (52) und durch die Montagelöcher (32) erstrecken, um die bewegliche Komponente (16) beweglich am Befestigungsrahmen (12) zu befestigen.

3. Der Befestigungsbügel nach Anspruch 1, wobei die Seitenwand (24) des Befestigungsrahmens (12) einen Anschlag (36) aufweist, der zu einem Fenster (40) der Seitenwand (24) ragt, wobei der Anschlag (36) entsprechend dem Ausrückglied (20) angeordnet ist.

4. Der Befestigungsbügel nach Anspruch 1, wobei die Montageeinheit (14) zwei Einbauglieder (42) aufweist, wobei zwischen diesen beiden Einbaugliedern (42) ein Positionierblock (44) und durch den Positionierblock (44) ein Gewindeloch (46) gebildet ist, wobei dieses Gewindeloch (46) entsprechend der Endwand (26) des Befestigungsrahmens (12) gebildet ist.

5. Der Befestigungsbügel nach Anspruch 1, wobei das Ausrückglied (20) mit einem Betätigungsteil (76) gebildet ist, während sich zwischen dem Schiebeblock (74) und dem Betätigungsteil (76) ein Montageteil (78) erstreckt; der Schiebeblock (74) mit einer geneigten Fläche (80) gebildet und dieser Schiebeblock (74) in Übereinstimmung mit der Betätigungslasche (70) des Positioniergliedes (18) angeordnet ist.

6. Der Befestigungsbügel nach Anspruch 1, wobei der Schiebeblock (74) des Ausrückgliedes (20) ein Halsteil (82) aufweist, das am Montageteil (78) befestigt ist, während das erste Plättchen (48) mit einem Schlitz (56) gebildet ist, durch den sich das Halsteil (82) erstreckt, um das Ausrückglied (20) beweglich am Trägerrahmen (54) der beweglichen Komponente (16) zu befestigen.

7. Der Befestigungsbügel nach Anspruch 6, wobei die Seitenwand (24) des Befestigungsrahmens (12) mit einem Anschlag (36) gebildet ist, der in Übereinstimmung mit dem Schiebeblock (74) oder mit dem Halsteil (82) angeordnet ist, damit das Ausrückglied (20) nicht von der beweglichen Komponente (16) abgetrennt wird.

## Revendications

1. Un support de montage (10) relié à un ensemble coulissant (84) et installé sur une tige (86) d'une crémaillère, la tige (86) ayant une pluralité de trous (88), le support de montage (10), comprenant :
un cadre de fixation (12) ayant une paroi latérale (24), une paroi d'extrémité (26), et deux saillies (28a, 28b) se prolongeant respectivement à partir du côté supérieur et du côté inférieur de la paroi latérale (24), les deux saillies (28a, 28b) et la paroi latérale (24) définissant un premier trajet (30), la paroi latérale (24) comportant un évidement (34) et définissant un second trajet (38);
une unité d'installation (14) fixée à la paroi d'extrémité (26) du cadre de fixation (12) ;
un élément mobile (16) ayant un premier bord (48) et un second bord (50), le premier bord (48) inséré dans le premier trajet (30) du cadre de fixation (12) ; le premier bord (48) ayant une partie de contact (58) et un cadre de support (54) ; le cadre de support (54) est inséré dans le deuxième trajet (38) du cadre de fixation (12) et la partie de contact (58) située de manière adjacente au second bord (50), le cadre de support (54) a un trou d'engagement (62), le second bord (50) ayant une pluralité de trous (64) qui sont situés pour correspondre avec l'unité d'installation (14) ;
un élément de positionnement (18) a une partie de fixation (66), un bras élastique (68), une partie d'activation (70) et une partie d'engagement (72) ; la partie de fixation (66) est fixée à la paroi latérale (24) du cadre de fixation (12) ; le bras élastique (68) est connecté entre la partie de fixation (66) et la partie d'activation (70) ; la partie d'activation (70) se prolonge selon un angle à partir d'une extrémité du bras élastique (68) ; la partie d'engagement (72) est située sur le bras élastique (68) et située pour correspondre au trou d'engagement (62) de l'élément mobile (16) ;
un élément de libération (20) est relié de manière mobile au premier bord (48) de l'élément mobile (16) et comporte un bloc de poussée (74), qui est situé pour correspondre avec la partie d'activation (70) de l'élément de positionnement (18) ;
et lors de l'assemblage, la partie de contact (58) de l'élément mobile (16) et le second bord (50) sont adaptés pour être en contact avec l'intérieur (87a) et l'extérieur (87b) de la tige (86) de la crémaillère ; l'unité d'installation (14) est située pour correspondre avec les trous (88) du montant (86) ; le cadre de fixation (12) est poussé vers la tige (86) pour insérer l'unité d'installation (14) dans les trous (88) de la tige (86) ; seule la partie d'engagement (72) de l'élément de positionnement (18) est en contact avec le trou d'engagement (62) de l'élément mobile (16) pour relier l'élément mobile (16) au cadre de fixation (12) et
lorsque l'on pousse l'élément de libération (20), le bloc de poussée (74) de l'élément de libération (20) entre en contact avec la partie d'activation (70) de l'élément de positionnement (18) ; le bras élastique (68) de l'élément de positionnement (18) est soulevé par rapport à l'élément mobile (16) ; la partie d'engagement (72) de l'élément de positionnement (18) est dégagée du trou d'engagement (62) de l'élément mobile (16) ; l'élément mobile (16) est mobile par rapport au cadre de fixation (12) ; l'unité d'installation (14) du support de montage (10) est adaptée pour être retirée de la tige (86).

2. Le support de montage selon la revendication 1, dans lequel la paroi latérale (24) du cadre de fixation (12) présente deux trous de connexion (32) ; le premier bord (48) de l'élément mobile (16) comporte deux trous traversants (52) situés pour correspondre aux trous de connexion (32) de la paroi latérale (24) ; les trous traversants (52) sont respectivement liés avec les trous de connexion (32) ; les trous traversants (52) ou les trous de connexion (32) ont la forme de fentes allongées ; deux éléments de connexion (60) passent au travers des trous traversants (52) et des trous de connexion (32) pour relier de façon mobile l'élément mobile (16) au cadre de fixation (12).

3. Le support de montage selon la revendication 1, dans lequel la paroi latérale (24) du cadre de fixation (12) présente une butée (36) qui se prolonge vers une fenêtre (40) de la paroi latérale (24) ; la butée (36) est située pour correspondre à l'élément de libération (20).

4. Le support de montage selon la revendication 1, dans lequel l'unité d'installation (14) présente deux éléments de montage (42) et un bloc de positionnement (44) situé entre les deux éléments de montage (42) ; le bloc de positionnement (44) présente un trou taraudé (46) ; et le trou taraudé (46) est situé pour correspondre à la paroi d'extrémité (26) du cadre de fixation (12).

5. Le support de montage selon la revendication 1, dans lequel l'élément de libération (20) comporte une partie d'actionnement (76) et une partie de connexion (78) se prolongeant entre le bloc de poussée (74) et la partie d'actionnement (76) ; le bloc de poussée (74) présente une face inclinée (80) située pour correspondre à la partie d'activation (70) de l'élément de positionnement (18).

6. Le support de montage selon la revendication 1, dans lequel le bloc de poussée (74) de l'élément de libération (20) comporte un col (82) relié à la partie de connexion (78) et le premier bord (48) présente une fente (56) par laquelle le col (82) se prolonge de sorte que l'élément de libération (20) est relié de manière mobile au cadre de support (54) de l'élément mobile (16).

7. Le support de montage selon la revendication 6, dans lequel la paroi latérale (24) du cadre de fixation (12) présente une butée (36), qui est située pour correspondre au bloc de poussée (74) ou le col (82), de telle sorte que l'élément de libération (20) ne puisse pas être séparé de l'élément mobile (16).
